(19) 

**Europäisches Patentamt**

**European Patent Office**

**Office européen des brevets**

(11) **EP 3 080 626 B1**

(12) **FASCICULE DE BREVET EUROPEEN**

(45) Date de publication et mention de la délivrance du brevet:
**22.02.2023 Bulletin 2023/08**

(21) Numéro de dépôt: **14827480.6**

(22) Date de dépôt: **09.12.2014**

(51) Classification Internationale des Brevets (IPC):
***G01R 31/36*** *(2006.01)*

(52) Classification Coopérative des Brevets (CPC):
**G01R 31/392; G01R 31/396;** Y02E 60/10;
Y02T 10/70

(86) Numéro de dépôt international:
**PCT/FR2014/053230**

(87) Numéro de publication internationale:
**WO 2015/086980 (18.06.2015 Gazette 2015/24)**

(54) **PROCÉDÉ D'ESTIMATION DES CAPACITÉS RÉSIDUELLES D'UNE PLURALITÉ DE BATTERIES**

VERFAHREN ZUR SCHÄTZUNG DER RESTKAPAZITÄTEN EINER MEHRZAHL VON BATTERIEN

METHOD OF ESTIMATING THE RESIDUAL CAPACITIES OF A PLURALITY OF BATTERIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.12.2013 FR 1362590**

(43) Date de publication de la demande:
**19.10.2016 Bulletin 2016/42**

(73) Titulaire: **Renault s.a.s**
**92100 Boulogne Billancourt (FR)**

(72) Inventeurs:
• **CHAZAL, Yann**
**F-75015 Paris (FR)**
• **CHANTREL, Cedric**
**F-94220 Charenton le Pont (FR)**
• **TRINH, Do-Hieu**
**F-78330 Fontenay le Fleury (FR)**
• **TOUSSAINT, Philippe**
**F-78000 Versailles (FR)**
• **UMLAWSKI, Mathieu**
**F-78000 Versailles (FR)**

(74) Mandataire: **Renault Group**
**Renault s.a.s.**
**API : TCR GRA 2 36**
**1, Avenue du Golf**
**78084 Guyancourt Cedex (FR)**

(56) Documents cités:
**EP-A1- 1 505 401      EP-A1- 2 583 858**
**WO-A1-2009/120195    WO-A1-2013/182438**
**US-A1- 2012 159 220   US-A1- 2012 249 048**
**US-A1- 2013 030 739**

• **WINDARKO N A ET AL: "Hysteresis modeling for estimation of State-of-Charge in NiMH battery based on improved Takacs model", TELECOMMUNICATIONS ENERGY CONFERENCE, 2009. INTELEC 2009. 31ST INTERNATIONAL, IEEE, PISCATAWAY, NJ, USA, 18 octobre 2009 (2009-10-18), pages 1-6, XP031579295, ISBN: 978-1-4244-2490-0**

**EP 3 080 626 B1**

**Description**

**Domaine de l'invention**

L'invention concerne un procédé d'estimation des capacités résiduelles d'une pluralité de batteries connectées.

Cette invention peut s'appliquer quel que soit le type de batterie.

**Etat de la technique**

Il est connu de connecter une pluralité de batteries pour alimenter un réseau de distribution d'énergie. En particulier, des batteries de véhicule électrique peuvent être recyclées afin d'être utilisées dans un environnement stationnaire. Ces batteries n'ayant plus assez d'énergie pour une utilisation embarquée telle que dans des véhicules électriques peuvent en revanche être utilisées dans un environnement stationnaire car elles sont capables d'emmagasiner de l'énergie et de le restituer à d'autres moments selon les besoins.

Dans le domaine, on connaît déjà de US20120249048 un dispositif de détermination de charge/décharge de batteries pour la gestion d'une installation de production d'énergie électrique naturelle (e.g. éolienne ou photovoltaïque), le dispositif comprenant une phase de stockage d'énergie pour stocker de l'énergie pendant des périodes de production d'énergie électrique naturelle et une phase de déstockage de l'énergie pour restituer cette énergie en dehors des périodes de production. US20120249048 décrit la régulation de l'apport des batteries en utilisant des informations d'état de la batterie qui varient avec le temps, notamment l'état de charge de la batterie, l'état de vieillissement de la batterie, ainsi que des mesures de tension ou de courant aux bornes de la batterie lorsqu'elle est en charge ou en décharge.

Il a été constaté que ce type de dispositif présente l'inconvénient d'être peu précis et ne prend pas en compte tous les éléments nécessaires pour estimer l'énergie réellement utilisable de la batterie. De plus, il implique des interventions périodiques de contrôle par un opérateur afin de prendre des mesures permettant d'estimer diverses caractéristiques de la batterie, comme son état de vieillissement. Il en résulte une augmentation des coûts de fonctionnement des batteries connectées pour alimenter un réseau de distribution d'énergie (e.g. personnels et matériels de maintenance), ainsi que des périodes d'indisponibilité des batteries pendant les opérations de contrôle.

**Objet de l'invention**

Dans ce contexte, l'invention a pour but de surmonter au moins certains des inconvénients précités, notamment d'optimiser les coûts de fonctionnement. Elle a également pour but de garantir un niveau minimum d'énergie pour alimenter un réseau de distribution d'énergie, améliorer la précision du contrôle de la capacité résiduelle de chaque batterie pour estimer l'énergie réellement utilisable par la batterie et prendre en compte la dégradation des composants dûs à leur vieillissement. Est également visé la réduction des équipements nécessaires pour gérer les capacités résiduelles de cette pluralité de batterie. Est aussi visée la réduction des coûts liés à d'éventuels manquements au respect des consignes pour garder la pluralité de batteries dans un état de fonctionnement, la prise en compte de l'état de dégradation des batteries ; en d'autres termes, sont visées la fiabilité et la sûreté de fonctionnement du procédé dans le temps. Enfin, l'invention vise à automatiser le procédé et éviter des interventions manuelles lourdes nécessitant l'isolation de la batterie par rapport à son environnement.

La solution proposée consiste en un procédé selon la revendication indépendante 1 et un système selon la revendication indépendante 8.

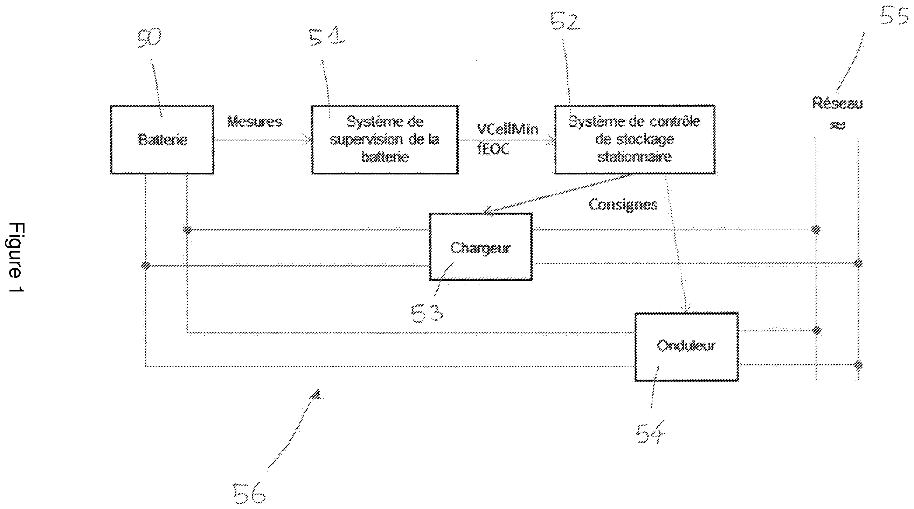

**Brève description de la figure 1**

La figure 1 montre un exemple d'architecture du système de stockage stationnaire.

**Description d'exemples de réalisation de l'invention**

Selon l'invention, le procédé comprend une première phase de stockage d'énergie pour stocker dans une pluralité de batteries 50 de l'énergie provenant d'un réseau 55 de distribution d'énergie et une deuxième phase de déstockage de l'énergie pour restituer l'énergie sur le réseau 55 de distribution d'énergie. Le procédé comporte les étapes suivantes :

- recueillir des informations relatives à des grandeurs physiques pour déterminer l'état de vieillissement de chacune des batteries 50 parmi ladite pluralité de batterie 50,
- sélectionner une batterie 50 parmi ladite pluralité de batterie 50 à partir des informations recueillies et/ou d'informations relatives à une planification de l'utilisation des batteries et/ou d'une consigne utilisateur,
- durant ladite première phase de stockage d'énergie, charger prioritairement ladite batterie (50) sélectionnée jusqu'à l'atteinte d'un niveau de charge maximale prédéfini dépendant de l'état de vieillissement,
- durant ladite deuxième phase de déstockage d'énergie, décharger prioritairement ladite batterie sélectionnée jusqu'à l'atteinte d'un niveau de charge minimale prédéfini, ou mettre au repos ladite batterie sélectionnée si elle n'a pas encore atteint le niveau de charge maximale prédéfini dépendant de l'état de vieillissement, puis mesurer un niveau d'énergie débitée $E_{resChk}$ par ladite batterie (50) sélectionnée. Le procédé peut en outre comprendre une étape dans laquelle, il faut mettre au repos ladite batterie si elle présente encore un état de charge supérieur audit niveau de charge minimale prédéfini, alors que le système est repassé dans une phase de stockage.

- calculer une capacité résiduelle de la batterie 50 sélectionnée à partir de la mesure du niveau d'énergie débitée $E_{resChk}$ par ladite batterie 50.

Préférentiellement, l'ensemble des étapes présentées ci-avant sont implémentées par un système 56 de stockage stationnaire.

En fonction de son vieillissement, les performances de la batterie 50 peuvent varier fortement pendant son utilisation. Le système 56 de stockage stationnaire contrôle ces informations.

La principale fonction du système 56 de stockage stationnaire, est d'implémenter la gestion des informations sur l'état de chaque batterie 50 composant la pluralité de batteries 50 afin de permettre une utilisation de la pluralité de batteries 50 au maximum de ses capacités énergétiques.

Le système de stockage stationnaire est capable de recueillir les informations relatives à des grandeurs physiques pour déterminer l'état de vieillissement d'une batterie. Ces informations peuvent être les suivantes (liste non exhaustive):

- la température en différents points de la batterie,
- le courant et la tension totale de la batterie,
- la tension de chaque cellule de la batterie,
- l'état de charge de la batterie,
- l'énergie disponible restante en décharge, la puissance disponible en décharge.

Toute batterie 50 se dégrade au cours du temps, c'est-à-dire que sa capacité totale diminue régulièrement au cours du temps, principalement pour deux raisons :

- la dégradation calendaire liée au temps d'utilisation de la batterie aux différents états de charge de la batterie (entre 0 et 100%) et aux températures à laquelle elle a été soumise,
- la dégradation liée au cyclage de la batterie 50, liée à l'énergie déjà déchargée par la batterie 50.

Comme montré sur la figure 1, le système 56 de stockage stationnaire des capacités résiduelles d'une pluralité de batteries 50 comprend les éléments suivants :

- une batterie 50,
- un système 51 de supervision de la batterie,
- un système 52 de contrôle de stockage stationnaire,
- un chargeur 53,
- un onduleur 54.

Ces éléments forment le système 56 de stockage stationnaire. Ce système 56 de stockage stationnaire est connecté au réseau 55 de courant alternatif.

Le système 51 de supervision de la batterie 50 fait l'acquisition de grandeurs physiques de la batterie (mesures températures, tensions de chacune des cellules, courant, etc.). Ces grandeurs physiques ont notamment pour fonction de déterminer l'état de vieillissement de la batterie 50. Le système 51 de supervision de la batterie 50 fait des calculs à partir de ces mesures afin, par exemple, de déterminer :

- une tension minimale des cellules $V_{CellMin}$ ;
- une première valeur binaire indiquant si la charge est terminée $f_{EOC} = 1$ ou $f_{EOC} = 0$ ;
- une puissance de charge $P_{CHG,HVB}$ ou une puissance de décharge $P_{DCHG,HVB}$ que la batterie 50 peut supporter sans qu'elle soit endommagée ;
- une tension $V_{HVB}$ et un courant $I_{HVB}$ mesurés aux bornes de la batterie 50 ;
- une quantité d'énergie $E_{HVB}$ disponible de la batterie 50.

Le système de supervision 51 de la batterie 50 communique les grandeurs physiques permettant de déterminer l'état de vieillissement de la batterie 50 au système 52 de contrôle de stockage stationnaire.

Le chargeur 53 et l'onduleur 54 communiquent avec le système 52 de contrôle de stockage stationnaire la puissance réalisable, $P_{BCB}$ et $P_{INV}$ respectivement.

Dans un mode de réalisation, les informations recueillies relatives à des grandeurs physiques pour déterminer l'état de vieillissement de la batterie sont également traitées pour détecter la présence d'une anomalie des grandeurs physiques dans la batterie. Ensuite, la batterie 50 présentant une anomalie des grandeurs physiques est sélectionnée prioritairement pour être chargée, les informations relatives à la planification de l'utilisation des batteries et/ou la consigne utilisateur étant moins prioritaires. Préférentiellement, c'est le système 56 de contrôle de stockage stationnaire qui traite ces informations recueillies.

Le système 52 de contrôle de stockage stationnaire est soumis à certaines contraintes énergétiques. Par exemple, le système 52 de contrôle de stockage stationnaire peut demander à charger la batterie 50 pendant les heures creuses et de la décharger pendant les heures pleines.

Comme montré sur la figure 1, le système 52 de contrôle de stockage stationnaire établit des consignes de charge ou décharge en fonction des informations qu'il reçoit et de ses contraintes énergétiques. Les consignes sont envoyées vers le chargeur 53 ou l'onduleur 54 pour être réalisées : on charge ou on décharge la batterie 50.

Dans le cadre d'une prestation, le niveau d'énergie minimum garanti au client est $E_{2nd,MIN}$. L'objectif de la procédure est de vérifier si la capacité résiduelle, $E_{ResChk}$, est suffisante par rapport au niveau d'énergie minimum garanti $E_{2nd,MIN}$. Si ce n'est pas le cas, il faut envisager soit de modifier le comportement du système 52 de contrôle de stockage stationnaire pour garantir la niveau d'énergie minimum garanti $E_{2nd,MIN}$, par exemple, en chargeant davantage la batterie 50, soit de changer la batterie 50 connectée à la pluralité d'autres batteries 50, pour une autre batterie 50 disposant d'une capacité résiduelle supérieure.

Le système 52 de contrôle de stockage stationnaire effectue l'essentiel des calculs nous intéressant dans le cadre de la présente invention.

Ainsi, la première valeur binaire indiquant si la charge est terminée pour la batterie 50 est égale à $f_{EOC2nd} = 1$ si la tension minimale des cellules $V_{CellMin}$ est supérieure ou égale à la tension de fin de charge $V_{cellEOC}$. La tension de fin de charge $V_{CellEOC}$ correspond à la valeur souhaitée de tension en fin de charge ; la tension $V_{CellEOC}$ est ajustable en fonction du résultat de la procédure de vérification de la capacité résiduelle. Sa valeur initiale est déterminée en fonction de l'état de vieillissement de la batterie 50 afin que la batterie 50 chargée ($fEOC_{2nd} = 1$) dispose d'une quantité s'énergie supérieure ou égale à $E_{2nd,MIN}$.

Une deuxième valeur binaire $f_{EODC2nd}$ indique que la décharge est terminée pour la batterie 50 ; si la puissance de décharge $P_{DCHG}$ est inférieure ou égale à une puissance seuil, alors $f_{EODC2nd} = 1$.

Le système 52 de contrôle de stockage stationnaire peut limiter son fonctionnement. Plus précisément, il peut interdire la décharge de la pluralité de batteries 50, seule la charge étant alors possible. Il peut également interdire la charge de la pluralité de batteries, seule la décharge étant alors possible. Bien entendu, le système 52 de contrôle de stockage stationnaire peut être configuré pour que la charge et la décharge soient possibles. Ces choix sont opérés en fonction de l'état du réseau de distribution d'énergie. A titre d'exemple, un bâtiment peut avoir des phases où il nécessite un apport d'énergie électrique supplémentaire (le procédé étant alors dans sa deuxième phase de déstockage). Dans ce cadre, l'apport de la présente invention permet cet apport d'énergie électrique supplémentaire. Dans le cas où le réseau de distribution d'énergie alimente le bâtiment en excès, alors la pluralité de batteries 50 connectés sera dans sa première phase de stockage d'énergie. Dans ce contexte, l'interdiction de charge ou de la décharge de la pluralité de batteries 50 est utile.

La procédure de contrôle de la capacité résiduelle de chaque batterie se compose notamment de quatre étapes :

- déclenchement de la procédure,
- charger la batterie jusqu'à l'obtention de la première valeur binaire ($f_{EOC} = 1$ ou $f_{EOC2nd} = 1$),
- décharger la batterie jusqu'à l'obtention de la deuxième valeur binaire $f_{EODC2nd} = 1$. Pendant la décharge on mesure la quantité d'énergie déchargée $E_{resChk}$(en kWh),
- ajustement du comportement du système 52 de contrôle de stockage stationnaire par rapport au résultat de la décharge ; par exemple si le niveau d'énergie $E_{resChk}$ est inférieur au niveau d'énergie minimum garanti $E_{2nd,MIN}$ de la batterie 50, il pourra par exemple être décidé de mettre cette batterie 50 au rebut.

Plusieurs mécanismes ont été mis en place pour déclencher la procédure de contrôle de la capacité résiduelle :

- les étapes de recueil des informations relatives à des grandeurs physiques pour déterminer l'état de vieillissement de chacune des batteries 50 parmi ladite pluralité de batterie 50, de sélection d'une batterie 50 parmi ladite pluralité de batterie 50 à partir des informations recueillies et/ou d'informations relatives à une planification de l'utilisation des batteries et/ou d'une consigne utilisateur, de chargement prioritaire de ladite batterie 50 sélectionnée durant la première phase de stockage, de déchargement prioritaire de ladite batterie sélectionnée durant la deuxième phase de déstockage, de mesure du niveau d'énergie débitée $E_{resChk}$ par ladite batterie 50 sélectionnée et de calcul de la capacité résiduelle de la batterie 50 sélectionnée à partir de la mesure du niveau d'énergie débitée $E_{resChk}$ par ladite batterie, sont déclenchées régulièrement, préférentiellement périodiquement, à une fréquence déterminée ;
- les étapes de recueil des informations relatives à des grandeurs physiques pour déterminer l'état de vieillissement de chacune des batteries 50 parmi ladite pluralité de batterie 50, de sélection d'une batterie 50 parmi ladite pluralité de batterie 50 à partir des informations recueillies et/ou d'informations relatives à une planification de l'utilisation des batteries et/ou d'une consigne utilisateur, de chargement prioritaire de ladite batterie 50 sélectionnée durant la première phase de stockage, de déchargement prioritaire de ladite batterie sélectionnée durant la deuxième phase de déstockage, de mesure du niveau d'énergie débitée $E_{resChk}$ par ladite batterie 50 sélectionnée et de calcul de la capacité résiduelle de la batterie 50 sélectionnée à partir de la mesure du niveau d'énergie débitée $E_{resChk}$ par ladite batterie, sont déclenchées par une consigne donnée par un utilisateur et communiquée audit système 56 de stockage stationnaire (préférentiellement au système 52 de contrôle de stockage stationnaire) ; un opérateur humain peut alors donner un ordre pour déclencher la procédure, soit immédiatement, soit à une heure déterminée.

La sélection de la batterie 50 parmi ladite pluralité de batterie 50 se fait à partir des informations recueillies et/ou d'informations relatives à une planification de l'utilisation des batteries à laquelle peut s'ajouter la consigne utilisateur susmentionnée. Sont ici entendues par informations relatives à une planification de l'utilisation des batteries, des informations relatives à un ordre prédéterminé et arbitraire ou selon des critères tels que le type de batterie ou la capacité nominale de la batterie, indépendamment d'informations relatives à leur état de vieillissement.

Lorsque le système 56 de stockage stationnaire est composé de plusieurs batteries, on prendra soin de lancer le procédé sur une batterie 50 à la fois. Il s'agit de préserver au maximum la disponibilité du système 56 pour l'utilisateur, en demandant aux autres batteries 50 du système 56 de prendre en charge le travail que la batterie 50 en cours de vérification ne peut assumer temporairement, par exemple lors de la deuxième phase de déstockage de l'énergie.

Pour compléter la charge de la batterie 50 à contrôler, le système 52 de contrôle de stockage stationnaire profite des phases où le besoin du bâtiment consiste à stocker de l'énergie. Dans ces conditions, lors de la première phase de stockage, la batterie 50 soumise au contrôle de capacité sera prioritaire (au regard des autres batteries du système complet) et profitera de la séquence pour augmenter son niveau de charge (pilotage de son chargeur par le système 52 de contrôle de stockage stationnaire).

A l'inverse, la batterie 50, en cours de chargement et qui n'a pas encore dépassé le niveau de charge maximale prédéfini sera maintenue au repos dans la deuxième phase de déstockage de l'énergie, où le besoin de l'utilisateur consiste à déstocker de l'énergie, les autres batteries 50 du système seront alors mises à contribution. Il s'agit là d'un élément clé de la présente invention. C'est pourquoi le système 52 de contrôle de stockage stationnaire interdit alors la décharge de la batterie dont le niveau de charge est inférieur au niveau de charge maximale prédéfini et établit que :

- la puissance de décharge $P_{DCHG}$ est nulle,
- $P_{CHG, MIN} = min(P_{CHG, LIM}, P_{CHG,HVB}, P_{BCB})$ où $P_{CHG, MIN}$ est la puissance maximale réalisable pour la charge en fonction de la précision des instruments du mesure du système de stockage ; $P_{CHG,HVB}$ est la puissance de charge que la batterie peut supporter sans qu'elle soit endommagée ; $P_{BCB}$ est la puissance réalisable du chargeur 53 ;
- $P_{CHG, MAX} = min(P_{CHG,HVB}, P_{BCB})$ où $P_{CHG, MAX}$ est la puissance maximale réalisable pour la charge ;
- $E_{CHG} = E_{2nd,MIN} - E_{2nd}$ où $E_{CHG}$ est l'énergie disponible pour la charge ; $E_{2nd}$ est l'énergie disponible de la batterie ; $E_{2nd,MIN}$ est le niveau d'énergie minimum garanti de la batterie ;
- l'énergie de décharge $E_{DCHG}$ est nulle.

Le système 52 de contrôle de stockage stationnaire établit également les consignes de charge qu'il envoie au chargeur 53, en fonction de ses besoins énergétiques. Cette étape est terminée si $f_{EOC2nd} = 1$ ou $f_{EOC} = 1$.

En ce qui concerne la décharge de la batterie 50 à contrôler, la procédure est analogue à celle utilisée pour la charge. En effet, le système 52 de contrôle de stockage stationnaire profitera de la deuxième phase de déstockage où le besoin de l'utilisateur consiste à déstocker de l'énergie, pour solliciter prioritairement la batterie 50 soumise au contrôle de la capacité résiduelle.

Pour assurer la répétabilité et la représentativité de la mesure, une contrainte supplémentaire est ajoutée sur la puissance de décharge de ladite batterie 50. Le système 52 de contrôle de stockage stationnaire fixe une valeur de puissance décharge prédéterminée pour décharger pendant la phase de décharge la batterie 50 sélectionnée, ladite batterie 50 sélectionnée ne se déchargeant qu'à cette valeur de puissance de décharge prédéterminée. Préférentiellement, la valeur de puissance de décharge prédéterminée est une valeur de puissance de décharge maximale, la batterie 50 sélectionnée cessant de se décharger si ledit réseau nécessite une valeur de puissance d'alimentation inférieure à ladite valeur de puissance de décharge maximale. La puissance d'alimentation correspond à la puissance exigée par le réseau pour alimenter les équipements électriques connectés à celui-ci. Dans ces conditions, seuls les besoins de l'utilisateur supérieurs à cette puissance permettront de poursuivre la décharge de ladite batterie 50.

Pendant cette étape, le système 52 de contrôle de stockage stationnaire interdit la charge et établit que :

- $P_{DCHG, MIN} = min(P_{DCHG,HVB}, P_{INV})$ où $P_{DCHG, MIN}$ est la puissance minimale réalisable pour la décharge en fonction de la précision des instruments du mesure du système de stockage ; $P_{DCHG,HVB}$ est la puissance de décharge que la batterie 50 peut supporter sans qu'elle soit endommagée ; $P_{INV}$ est la puissance réalisable de l'onduleur 54 ;
- la puissance de charge est nulle ;
- $P_{DCHG, MAX} = min(P_{DCHG,HVB}, P_{INV})$ où $P_{DCHG, MAX}$ est la puissance maximale réalisable pour la décharge en fonction de la précision des instruments du mesure du système de stockage ;
- l'énergie de charge $E_{CHG}$ est nulle ;
- l'énergie de décharge $E_{DCHG}$ est égale à l'énergie disponible de la batterie $E_{2nd}$.

Le système 52 de contrôle de stockage stationnaire établit également les consignes de décharge qu'il envoie à l'onduleur 54, en fonction de ses besoins énergétiques. Pour assurer la répétabilité des tests de décharge, le système 52 de contrôle de stockage stationnaire (préférentiellement le système 56 de contrôle de stockage stationnaire) augmente la puissance de décharge minimale de sorte que $P_{DCHG, MIN} = P_{DCHG, MAX}$.

Le système 52 de contrôle de stockage stationnaire réalise le comptage d'énergie débité $E_{ResChk}$ de la batterie 50, chaque fois que les besoins énergétiques lui permettent d'autoriser la décharge. Le niveau d'énergie débité se calcule de la manière suivante :

$$E_{ReSChk} = 0.001 \cdot \int V_{HVB} \cdot I_{HVB} \cdot dt$$

$V_{HVB}$ est la tension à laquelle la batterie se décharge. $I_{HVB}$ est l'intensité à laquelle la batterie se décharge. Cette étape est terminé si $f_{EODC} = 1$. Ce sont les valeurs de tension et courant mesurées aux bornes de la batterie.

Ainsi, après que la batterie sélectionnée soit complètement déchargée, le système de stockage stationnaire calcule le niveau d'énergie débitée $E_{resChk}$ par la batterie 50 sélectionnée. Le niveau d'énergie débitée $E_{resChk}$ est comparée audit niveau d'énergie minimum garanti $E_{2nd,MIN}$ de la batterie 50.

Si le niveau d'énergie débitée $E_{resChk}$ est supérieur ou égal au niveau d'énergie minimum garanti $E_{2nd,MIN}$ de la batterie 50, le système 56 de stockage stationnaire équipé du système 52 de contrôle de stockage stationnaire qui comprend un compteur de vérification de la capacité non satisfaisante, remet à zéro ce compteur.

Si le niveau d'énergie débitée $E_{resChk}$ est inférieur au niveau d'énergie minimum garanti de la batterie 50 :

- le compteur est incrémentée d'une unité à chaque comparaison des niveaux d'énergie débitée $E_{resChk}$ et d'énergie minimum garantie $E_{2nd,MIN}$ ;
- si le compteur dépasse une valeur seuil prédéterminée, alors des informations pour remplacer cette batterie 50 sont envoyées par le système 52 de stockage, ou, une tension de fin de charge de la batterie 50 est incrémentée.

## Revendications

1. Procédé d'estimation des capacités résiduelles d'une pluralité de batteries (50) connectées à un réseau (55) de distribution d'énergie électrique, ledit procédé comprenant une phase de stockage pour stocker dans la pluralité de batteries (50) de l'énergie provenant du réseau (55) et une phase de déstockage pour restituer l'énergie sur le réseau (55), le procédé incluant de :

   - recueillir (20,25) des informations relatives à des grandeurs physiques pour déterminer l'état de vieillissement de chacune des batteries (50) parmi ladite pluralité de batterie (50),
   - sélectionner (30,35) une batterie (50) parmi ladite pluralité de batterie (50) à partir des informations recueillies (20,25),
   - durant la phase de stockage d'énergie, charger prioritairement ladite batterie (50) sélectionnée jusqu'à l'atteinte d'un niveau de charge maximale prédéfini dépendant de l'état de vieillissement,
   - durant la phase de déstockage d'énergie, décharger prioritairement ladite batterie sélectionnée, si elle a atteint le niveau de charge maximale durant la phase de stockage, jusqu'à l'atteinte d'un niveau de charge minimale prédéfini dépendant de l'état de vieillissement, ou mettre au repos ladite batterie sélectionnée si elle n'a pas encore atteint le niveau de charge maximale prédéfini, et mesurer un niveau d'énergie débitée ($E_{resChk}$) par ladite batterie (50) sélectionnée entre lesdits niveau de charge maximale et niveau de charge minimale ;
   - calculer une capacité résiduelle de ladite batterie (50) sélectionnée à partir de la mesure du niveau d'énergie débitée ($E_{resChk}$) par ladite batterie entre lesdits niveau de charge maximale et niveau de charge minimale.

2. Procédé d'estimation selon la revendication 1, **caractérisé en ce qu**'il inclut, durant la phase de mesure du niveau d'énergie débitée ($E_{resChk}$), de mettre au repos ladite batterie si elle présente encore un état de charge supérieur audit niveau de charge minimale prédéfini, alors que le système est repassé dans une phase de stockage.

3. Procédé d'estimation selon l'une quelconque des revendications précédentes, **caractérisé en ce qu**'il inclut, de fixer une valeur de puissance de décharge prédéterminée pour décharger pendant la phase de déstockage la batterie (50) sélectionnée, ladite batterie (50) sélectionnée ne se déchargeant qu'à cette valeur de puissance de décharge prédéterminée, la batterie (50) sélectionnée cessant de se décharger si le réseau (55) nécessite une valeur de puissance d'alimentation inférieure à ladite valeur de puissance de décharge.

4. Procédé d'estimation selon l'une quelconque des revendications précédentes, **caractérisé en ce qu**'il inclut :

   - de traiter également les informations recueillies relatives à des grandeurs physiques pour détecter la présence d'une anomalie des grandeurs physiques dans la batterie,
   - de sélectionner prioritairement pour être chargée la batterie (50) présentant une anomalie des grandeurs physiques, les informations relatives à la planification de l'utilisation des batteries et/ou la consigne utilisateur étant alors moins prioritaires.

5. Procédé d'estimation selon l'une quelconque des revendications précédentes, **caractérisé en ce que** les étapes sont déclenchées régulièrement, préférentiellement périodiquement.

6. Procédé d'estimation selon l'une quelconque des revendications précédentes, **caractérisé en ce qu**'il est implémenté par un système de stockage stationnaire.

7.  Procédé d'estimation selon la revendication 5, **caractérisé en ce qu'**il inclut de comparer ledit niveau d'énergie débitée ($E_{resChk}$) à un niveau d'énergie minimum garanti ($E_{2nd,MIN}$) de la batterie (50) sélectionnée :

> • si le niveau d'énergie débitée est supérieur ou égal au niveau d'énergie minimum garanti, alors un compteur de vérification de la capacité non satisfaisante est remis à zéro,
> • si le niveau d'énergie débitée est inférieur au niveau d'énergie minimum garanti :
>
>> - alors le compteur est incrémenté d'une unité,
>> - si le compteur dépasse une valeur seuil prédéterminée, alors des informations pour remplacer cette batterie (50) sont envoyées, ou, une tension de fin de charge de la batterie (50) est incrémentée.

8.  Système d'estimation des capacités résiduelles d'une pluralité de batteries (50) **caractérisé en ce qu'**il comprend des moyens de mise en oeuvre du procédé selon l'une quelconque des revendications précédentes.

9.  Bâtiment comprenant un système selon la revendication 8.

**Patentansprüche**

1.  Verfahren zur Schätzung der Restkapazitäten einer Vielzahl von mit einem elektrischen Energieverteilungsnetz (55) verbundenen Batterien (50), wobei das Verfahren eine Speicherphase, um vom Netz (55) kommende Energie in der Vielzahl von Batterien (50) zu speichern, und eine Entnahmephase enthält, um die Energie in das Netz (55) abzugeben, wobei das Verfahren enthält:

> - Sammeln (20, 25) von Informationen bezüglich physikalischer Größen, um den Alterungszustand jeder der Batterien (50) unter der Vielzahl von Batterien (50) zu bestimmen,
> - Auswählen (30, 35) einer Batterie (50) unter der Vielzahl von Batterien (50) ausgehend von den gesammelten Informationen (20, 25),
> - während der Energiespeicherphase prioritär Laden der ausgewählten Batterie (50) bis zum Erreichen eines vom Alterungszustand abhängenden vordefinierten Pegels maximaler Ladung,
> - während der Energieentnahmephase prioritär Entladen der ausgewählten Batterie, wenn sie während der Speicherphase den Pegel maximaler Ladung erreicht hat, bis zum Erreichen eines vom Alterungszustand abhängenden vordefinierten Pegels minimaler Ladung oder Versetzen der ausgewählte Batterie in den Ruhezustand, wenn sie noch nicht den vordefinierten Pegel maximaler Ladung erreicht hat, und Messen eines Pegels einer von der ausgewählten Batterie (50) zwischen dem Pegel maximaler Ladung und dem Pegel minimaler Ladung abgegebenen Energie ($E_{resChk}$);
> - Berechnen einer Restkapazität der ausgewählten Batterie (50) ausgehend von der Messung des Pegels einer von der Batterie zwischen dem Pegel maximaler Ladung und dem Pegel minimaler Ladung abgegebenen Energie ($E_{resChk}$).

2.  Schätzverfahren nach Anspruch 1, **dadurch gekennzeichnet, dass** es während der Messphase des Pegels abgegebener Energie ($E_{resChk}$) enthält, die Batterie in den Ruhezustand zu versetzen, wenn sie noch einen Ladezustand höher als der vordefinierte Pegel minimaler Ladung aufweist, während das System wieder in eine Speicherphase übergegangen ist.

3.  Schätzverfahren nach einem der vorhergehenden Ansprüche, **dadurch gekennzeichnet, dass** es enthält, einen vorbestimmten Entladungsleistungswert festzulegen, um die ausgewählte Batterie (50) während der Entnahmephase zu entladen, wobei die ausgewählte Batterie (50) sich nur bis auf diesen vorbestimmten Entladungsleistungswert entlädt, wobei die ausgewählte Batterie (50) ihre Entladung beendet, wenn das Netz (55) einen Versorgungsleistungswert niedriger als der Entladungsleistungswert benötigt.

4.  Schätzverfahren nach einem der vorhergehenden Ansprüche, **dadurch gekennzeichnet, dass** es enthält:

> - ebenfalls die gesammelten Informationen bezüglich physikalischer Größen zu verarbeiten, um das Vorhandensein einer Anomalie der physikalischen Größen in der Batterie zu erfassen,
> - zum Laden prioritär die Batterie (50) auszuwählen, die eine Anomalie der physikalischen Größen aufweist, wobei die Informationen bezüglich der Planung der Verwendung der Batterien und/oder die Benutzeranweisung dann weniger prioritär sind.

5.  Schätzverfahren nach einem der vorhergehenden Ansprüche, **dadurch gekennzeichnet, dass** die Schritte regelmäßig, vorzugsweise periodisch, ausgelöst werden.

**6.** Schätzverfahren nach einem der vorhergehenden Ansprüche, **dadurch gekennzeichnet, dass** es von einem ortsfesten Speichersystem implementiert wird.

**7.** Schätzverfahren nach Anspruch 5, **dadurch gekennzeichnet, dass** es enthält, den Pegel abgegebener Energie ($E_{resChk}$) mit einem garantierten Mindestenergiepegel ($E_{2nd,MIN}$) der ausgewählten Batterie (50) zu vergleichen:

   • wenn der Pegel abgegebener Energie höher als der oder gleich dem garantierten Mindestenergiepegel ist, wird ein Zähler zur Überprüfung der nicht zufriedenstellenden Kapazität auf Null zurückgesetzt,
   • wenn der Pegel abgegebener Energie niedriger als der garantierte Mindestenergiepegel ist:

      - wird der Zähler um eine Einheit inkrementiert,

   • wenn der Zähler einen vorbestimmten Schwellwert überschreitet, werden Informationen zum Ersetzen dieser Batterie (50) geschickt, oder eine Ladeschlussspannung der Batterie (50) wird inkrementiert.

**8.** System zur Schätzung der Restkapazitäten einer Vielzahl von Batterien (50), **dadurch gekennzeichnet, dass** es Einrichtungen zur Durchführung des Verfahrens nach einem der vorhergehenden Ansprüche enthält.

**9.** Gebäude, das ein System nach Anspruch 8 enthält.

**Claims**

**1.** Method for estimating the residual capacities of a plurality of batteries (50) connected to an electric power distribution network (55), said method comprising a storage phase to store, in the plurality of batteries (50), energy coming from the network (55) and a release phase to return the energy to the network (55), the method including:

   - gathering (20, 25) information relating to physical quantities in order to determine the state of ageing of each of the batteries (50) from among said plurality of batteries (50),
   - selecting (30, 35) a battery (50) from among said plurality of batteries (50) based on the information gathered (20, 25),
   - during the energy storage phase, charging as a priority said selected battery (50) until a predefined maximum charge level, which is dependent on the state of ageing, is reached,

   - during the energy release phase, discharging as a priority said selected battery, if it has reached the maximum charge level during the storage phase, until a predefined minimum charge level, which is dependent on the state of ageing, is reached, or making said selected battery inactive if it has not yet reached the predefined maximum charge level, and measuring a level of energy yielded ($E_{resChk}$) by said selected battery (50) between said maximum charge level and minimum charge level,
   - calculating a residual capacity of said selected battery (50) based on the measurement of the level of energy yielded ($E_{resChk}$) by said battery between said maximum charge level and minimum charge level.

**2.** Estimating method according to Claim 1, **characterized in that** it includes, during the phase of measuring the level of energy yielded ($E_{resChk}$), making said battery inactive if it still exhibits a state of charge which is higher than said predefined minimum charge level, while the system is passed back into a storage phase.

**3.** Estimating method according to either one of the preceding claims, **characterized in that** it includes fixing a predetermined discharge power value in order to discharge, during the release phase, the selected battery (50), said selected battery (50) discharging only to this predetermined discharge power value, the selected battery (50) ceasing to discharge if the network (55) requires a supply power value which is lower than said discharge power value.

**4.** Estimating method according to any one of the preceding claims, **characterized in that** it includes:

   - also processing the gathered information relating to physical quantities in order to detect the presence of an anomaly in the physical quantities in the battery,
   - selecting as a priority, in order to be charged, the battery (50) exhibiting an anomaly in the physical quantities, the information relating to the planning of the use of the batteries and/or the user instruction then taking lower priority.

**5.** Estimating method according to any one of the preceding claims, **characterized in that** the steps are triggered regularly, preferably periodically.

**6.** Estimating method according to any one of the preceding claims, **characterized in that** it is implemented by a stationary storage system.

**7.** Estimating method according to Claim 5, **characterized in that** it includes comparing said level of energy yielded ($E_{resChk}$) with a guaranteed minimum energy level ($E_{2nd,MIN}$) of the selected battery (50) :

> • if the level of energy yielded is higher than or equal to the guaranteed minimum energy level, then an insufficient capacity check counter is reset,
> • if the level of energy yielded is lower than the guaranteed minimum energy level:
>
>> - then the counter is incremented by one unit,
>> - if the counter exceeds a predetermined threshold value, then information to replace this battery (50) is sent, or an end-of-charge voltage of the battery (50) is incremented.

8.  System for estimating the residual capacities of a plurality of batteries (50), **characterized in that** it comprises means for implementing the method according to any one of the preceding claims.

9.  Building comprising a system according to Claim 8.

Figure 1

**EP 3 080 626 B1**